# EUROPEAN PATENT SPECIFICATION

(11) **EP 0 632 596 B1**
(45) Date of publication and mention of the grant of the patent: **03.03.1999**
(21) Application number: 94304651.6
(22) Date of filing: 27.06.1994
(51) Int. Cl.: H03K 19/0952

(54) **Logic gate circuit formed of semiconductor transistors**
Logikgatter bestehend aus Halbleitertransistoren
Porte logique constituée de transistors à semi-conducteur

(30) Priority: 30.06.1993 JP 160544/93
(43) Date of publication of application: 04.01.1995
(73) Proprietor: FUJITSU LIMITED, Kawasaki-shi, Kanagawa 211 (JP)
(72) Inventor: Miyashita, Takumi, c/o Fujitsu Limited, Kawasaki-shi, Kanagawa 211 (JP)
(74) Representative: Fane, Christopher Robin King

(56) References cited:
- US-A- 4 716 311
- US-A- 5 182 473
- PATENT ABSTRACTS OF JAPAN vol. 14, no. 411 (E-0973) 5 September 1990 & JP-A-02 155 309 (OKI ELECTRIC CO LTD.) 14 June 1990
- PATENT ABSTRACTS OF JAPAN vol. 14, no. 502 (E-0997) 2 November 1990 & JP-A-02 209 011 (AGENCY OF IND SCIENCE AND TECHNOL.) 20 August 1990
- PATENT ABSTRACTS OF JAPAN vol. 14, no. 142 (E-904) 16 March 1990 & JP-A-02 005 618 (FUJITSU LTD.) 23 June 1988

## Description

The present invention relates to a logic gate circuit formed of semiconductor transistors, for example of compound semiconductor transistors such as MESFETs (Metal Semiconductor Field Effect Transistors) or HEMTs (High Electron Mobility Transistors).

In a circuit arrangement comprising an integrated circuit (e.g. of GaAs) having an output stage with a large fan out (such as a clock circuit or a bus driving circuit) and a logic gate circuit for providing an off-chip buffer for driving an external circuit, a good load drivability is desirable.

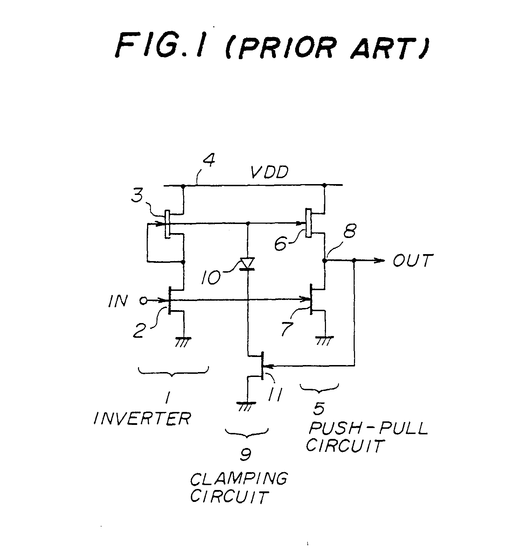

Conventionally, a circuit as shown in FIG. 1 of the accompanying drawings has been used for this type of logic gate circuit.

Referring to FIG. 1 of the accompanying drawings, the logic gate circuit has an inverter 1, a push-pull circuit 5 and a clamping circuit 9. The inverter 1 is formed as a logic gate stage and an input signal IN is supplied to the inverter 1. The input signal IN may have a high level (H-level) and a low level (L-level), the H-level being, for example, 0.7 volts and the L-level being, for example, 0 volts.

The inverter 1 has an enhancement-type MESFET 2 used as a driver and a depletion-type MESFET 3 which is used as a load. A power supply line 4 (VDD) is connected to the inverter 1. The power supply line 4 supplies a voltage, for example, of 2 volts.

The push-pull circuit 5 is formed as an output driver state. The push-pull circuit 5 has a depletion-type MESFET 6 used for the pull-up and an enhancement-type MESFET 7 used for the pull-down. An output signal OUT is output from an output node 8 at which the depletion-type MESFET 6 and the enhancement-type MESFET 7 are connected.

The clamping circuit 9 clamps the gate voltage of the depletion-type MESFET 6 at a constant voltage to cause a level at the output node 8 to be stable at 0.7 volts when the output signal OUT has the H-level. The clamping circuit 9 has a Schottky diode 10 and an enhancement-type MESFET 11.

In this logic gate circuit, when the input signal IN has the H-level equal to 0.7 volts, the output signal OUT has the L-level equal to 0 volts. On the other hand, when the input signal IN has the L-level equal to 0 volts, the output signal OUT has the H-level equal to 0.7 volts.

If the clamping circuit 9 is not provided in this logic gate circuit, the level of the output signal OUT exceeds 0.7 volts in response to the input signal IN having the L-level equal to 0 volts. As a result, a large amount of current flows from the power supply line 4 (VDD) to the next stage circuit connected to this logic gate circuit via the depletion-type MESFET 6.

To prevent the above, the clamping circuit 9 is provided in this logic gate circuit. If the level at the output node 8 exceeds 0.7 volts, the enhancement-type MESFET 11 is turned on. As a result, the gate voltage of the depletion-type MESFET 6 is decreased and clamped by the Schottky diode 10 so that the level at the output node 8 is made to be stable at 0.7 volts.

In this logic gate circuit, since the push-pull circuit 5 is provided in a post-stage for the inverter 1 formed as the logic gate stage, a large load drivability can be obtained.

However, although the clamping circuit 9 is provided in the logic gate circuit, when the level of the input signal, IN is switched to the L-level equal to 0 volts, the level of the output node 8 temporarily exceeds 0.7 volts and is then decreased to 0.7 volts. Thus, when the level of the output signal OUT is inverted from L-level to the H-level, a current independent of the logical inversion operation temporarily flows from the power supply line 4 (VDD) to a transistor in the next stage circuit via the depletion-type MESFET 6.

In addition, in this logic gate circuit, the depletion-type MESFET 6 for the pull-up in the push-pull circuit 5 has a low threshold level and is always in an on state. Thus, to maintain the level of the output signal OUT at the L-level, the W/L ratio of the enhancement-type MESFET 7 for the pull-down must be large, where W is the channel width and L is the channel length. As a result, the input capacitance is large, so that a high speed operation is prevented.

In JP-A-2209011 there is disclosed a push-pull circuit comprising two enhancement-mode MESFETs as a drive circuit and a Schottky diode for clamping the level of the gate of a MESFET of an inverter. With this arrangement through-current at the push-pull circuit is cut off and no waste current flows.

In JP-A-2005618 there is disclosed a logic circuit comprising a clamping circuit for clamping the low level output voltage of a directly coupled FET logic circuit.

In US-A-5182473 there is described with reference to Figure 14 of that document a logic gate circuit similar to that described hereinbelow with reference to Figure 2 of the accompanying drawings.

According to the invention there is provided a logic gate circuit comprising:
a logic gate stage having an input for receiving an input signal and an output for outputting a signal depending on a state of the input signal;
a push-pull circuit forming an output driver stage and having a pull-up circuit formed of an enhancement-type transistor and a pull-down circuit, said transistor having a drain connected to a first line to be maintained at a first voltage, a gate connected to receive the signal output from said logic gate stage and a source connected to said pull-down circuit, said pull-down circuit being connected to a second line to be maintained at a second voltage less than the first voltage and arranged to receive and be controlled by the input signal; and
a clamping circuit for clamping a gate voltage of said transistor at a limited voltage so that a node via which the source of said enhancement-type transistor and said pull-down circuit are connected has a high level, said node being an output terminal of said logic gate circuit and the clamping circuit having a further enhancement-type transistor, the clamping circuit comprising a Schottky diode, the anode of which is connected to a source of said further enhancement-type transistor and the cathode of which is connected to said second line, said further enhancement-type transistor having a drain connected to the gate of said first-mentioned enhancement-type transistor for the pull-up of said output driver stage, a gate connected to said node and a threshold voltage of approximately 0 volts, characterised by a further push-pull circuit additional to said first-mentioned pull-up circuit, forming an additional part of the output driver stage and having a further pull-up circuit formed of another enhancement-type transistor and a further pull-down circuit, said other enhancement-type transistor having a drain connected to the first line, a gate connected to receive the signal output from said logic gate stage and a source connected to said further pull-down circuit said further pull-down circuit being connected to the second line.

For a better understanding of the invention, and to show how the same may be carried into effect, reference will now be made, by way of example, to the accompanying drawings, in which:-
FIG. 1 is a circuit diagram of a conventional logic gate circuit;
FIG. 2 is a circuit diagram of a logic gate circuit forming a part of a circuit according to a first embodiment of the present invention;
FIG. 3 is a circuit diagram of an inverting buffer circuit according to a first embodiment, the buffer circuit incorporating the logic gate circuit of FIG. 2;
FIG. 4 shows in more detail a part of the inverting buffer circuit of FIG. 3;
FIG. 5 is a circuit diagram of an analog-to-digital converter;
FIG. 6 is a circuit diagram of the clock generator circuit of the analog-to-digital converter shown in FIG. 5 in which logic gate circuits embodying the present invention are present;
FIG. 7 is a circuit diagram of a second embodiment showing a part of the clock generator circuit of FIG. 6 in more detail, that part comprising a logic gate circuit, the logic gate stage of which being an inverter;
FIG. 8 is a circuit diagram of a third embodiment showing a further part of the clock generator circuit of FIG. 6 in more detail, that further part comprising a logic gate circuit, the logic gate stage of which being an OR gate; and
FIG. 9 is a circuit diagram of a fourth embodiment showing still further parts of the clock generator circuit of FIG. 6 in more detail, those still further parts comprising respective logic gate circuits, the respective logic gate stages of which being NOR gates.

A description will now be given of a logic gate circuit forming part of a circuit according to a first embodiment of the invention, the logic gate circuit having an inverter 24 as its logic gate stage, and an output driver circuit comprising a push-pull circuit 28 and a clamping circuit 37.

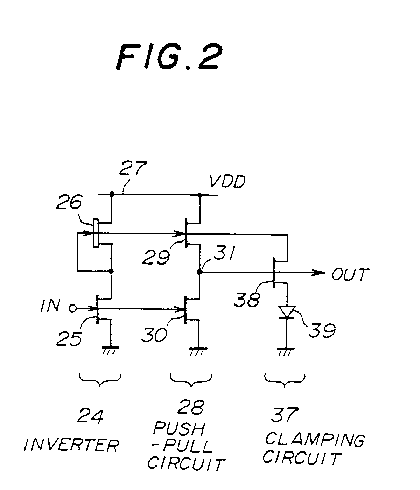

Referring to FIG. 2, the inverter circuit 24 is formed as the logic gate stage and an input signal IN is supplied to the inverter 24. The input signal may have the H-level which is equal, for example, to 0.7 volts and the L-level which is equal, for example, to 0 volts. The inverter 24 comprises an enhancement-type MESFET 25 used as a driver and a depletion-type MESFET 26 used as a load. A power supply line 27 having, for example, 2 volts (VDD) is connected to the inverter 24.

The push-pull circuit 28 is formed adjacent to the inverter circuit 24. The push-pull circuit 28 comprises an enhancement-type MESFET 29 for the pull-up and an enhancement-type MESFET 30 for the pull-down. A node 31 at which the enhancement-type MESFETs 29 and 30 are connected is formed as an output terminal.

The clamping circuit 37 has an enhancement-type MESFET 38 and a Schottky diode 39. The enhancement-type MESFET 38 is controlled in accordance with the level at the node 31 so as to be in the ON state or in the OFF state and have a threshold level of approximately 0 volts.

When the input signal IN has the H-level, the MESFET 25 is in the ON state, the drain of the MESFET 25 has the L-level, the enhancement-type MESFET 29 is in the OFF state and the MESFET 30 is in the ON state. As a result, the node 31 (the output signal OUT) has the L-level.

On the other hand, when the input signal IN has the L-level, the MESFET 25 is in the OFF state, the drain of the MESFET 25 has the H-level, the enhancement-type MESFET 29 is in the ON state and the MESFET 30 is in the OFF state. As a result, the node 31 (the output signal OUT) has the H-level.

The push-pull circuit 28 formed as the output driver stage is provided in the post-stage for the inverter 24 formed as the logic gate stage. Thus, a large load drivability can be obtained.

In addition, the MESFET 38 of the clamping circuit 37 has the drain connected to the gate of the enhancement-type MESFET 29 and the gate connected to the node 31 and has a threshold level of approximately 0 volts. The Schottky diode 39 of the clamping circuit 37 has its anode connected to the source of the MESFET 38 and its cathode connected to the ground line. As a result, when the level of the node 31 is switched from the L-level to the H-level, the MESFET 38 is in the OFF state until the level of the node 31 reaches a voltage equal to the forward voltage V_{DF} of the Schottky diode 39. In this case, when the level of the node reaches the voltage equal to the forward voltage V_{DF} of the Schottky diode 39, the MESFET 38 is turned on. As a result, the voltage at the node 31 is clamped to the forward voltage V_{DF} of the Schottky diode 39.

If the forward voltage V_{DF} of the Schottky diode 39 is equal to 0.7 volts (V_{DF} = 0.7), the level of the node 31 is equal to the 0.7 volts when the output signal OUT has the H-level. In this case, if the threshold voltage in the next stage circuit falls within a range of 0.3 - 0.5 volts, the input transistor in the next stage circuit can be turned on. In addition, when the level of the node 31 is switched from the L-level to the H-level, a current independent of the logical operation is prevented from flowing from the power supply line 27 (VDD) to the input transistor in the next stage circuit via the enhancement-type MESFET 29. Thus, a low dissipation power can be obtained.

The enhancement-type MESFET 29 provided as the pull-up transistor in the push-pull circuit 28 is not always in the ON state. That is, when the output signal OUT should have the H-level, the enhancement-type MESFET 29 is in the ON state, and when the output signal OUT should have the L-level, the enhancement-type MESFET 29 is in the OFF state. Thus, the W/L ratio of the MESFET 30 for the pull-down can be small so that the input capacitance can be low.

As has been described above, according to this design, in the inverter with the output driver circuit, a large load drivability can be obtained and power dissipation and input capacitance kept low. In addition, when the output signal OUT has the H-level, the level at the node 31 is relatively high. As a result, the processing speed in the circuit can be relatively high.

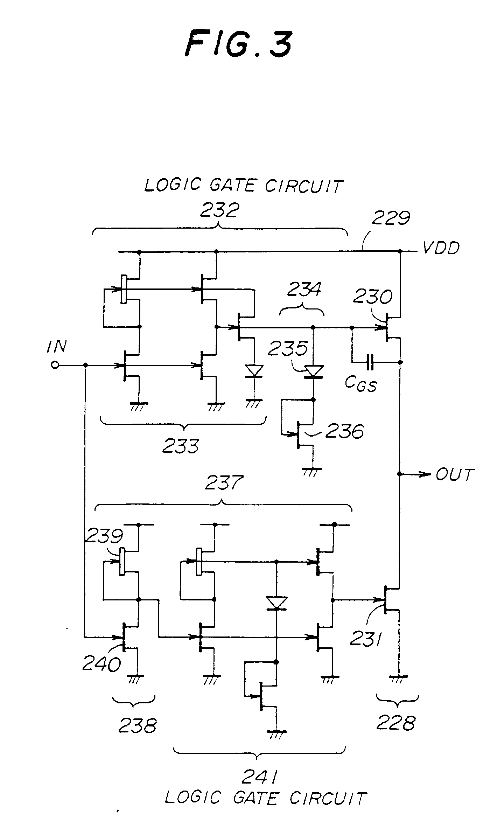

A description will now be given, with reference to FIG. 3, of an inverting buffer circuit according to the first embodiment in which the logic gate circuit of FIG. 2 is present.

Referring to FIG. 3, the inverting buffer circuit has a push-pull circuit 228, a pull-up control circuit 232 and a pull-down control circuit 237. A power supply line 229 has a predetermined voltage (VDD). The push-pull circuit 228 is formed of an enhancement-type MESFET 230 for the pull-up and an enhancement-type MESFET 231 for the pull-down.

The pull-up control circuit 232 controls the MESFET 230 so that the MESFET 230 is turned on or off. The pull-up control circuit 232 comprises a logic gate circuit 233, having the same structure as the circuit of FIG. 2, and a further clamping circuit 234 for restraining the increase of the gate voltage of the MESFET 230 caused by the bootstrap of a capacitance C_{G5} between the gate and source of the MESFET 230. The clamping circuit 234 is formed of a Schottky diode 235 and an enhancement-type MESFET 236 connected to the Schottky diode 235. The further clamping circuit 234 is not absolutely necessary and can be omitted.

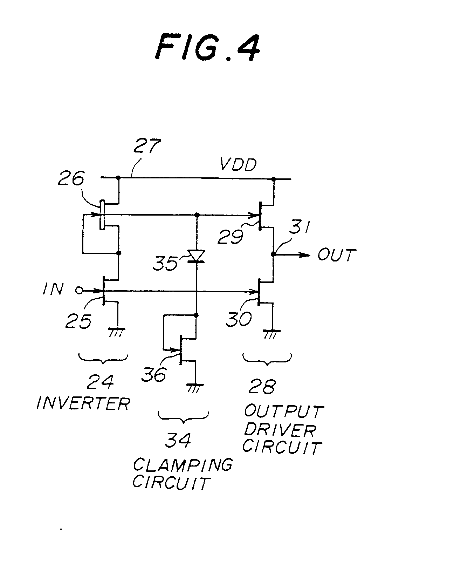

The pull-down control circuit 237 has an inverter 238 used as an input circuit and a logic gate circuit 241 described in more detail below with reference to FIG. 4. The pull-down control circuit 237 controls the MESFET 231 so that the MESFET is turned on or off. The inverter 238 is formed of a depletion-type MESFET 239 for a load and an enhancement-type MESFET 240 for a driver.

Referring to FIG. 4, the logic gate circuit 241 of FIG. 3 comprises an inverter 24, a clamping circuit 34 and an output driver circuit 28. The inverter 24 and output driver circuit 28 are similar to those described with reference to FIG. 2, but the clamping circuit 34 is different and is now described in more detail.

That is, the clamping circuit 34 has a Schottky diode 35 and an enhancement-type MESFET 36 connected to the Schottky diode 35.

When the input signal IN has the H-level, the MESFET 25 is in the ON state, the drain of the MESFET 25 has the L-level, the enhancement-type MESFET 29 is in the OFF state and the MESFET 30 is in the ON state. As a result, the node 31 (the output signal OUT) has the L-level.

When the input signal IN has the L-level, the MESFET 25 is in the OFF state, the enhancement-type MESFET 29 is in the ON state and the MESFET 30 is in the OFF state, the node 31 (the output signal OUT) has the H-level.

Also, since the push-pull circuit 28 formed as the output driver stage is provided in the post-stage for the inverter 24 formed as the logic gate stage, a large load drivability can be obtained.

In addition, the clamping circuit 34 has the Schottky diode 35 and the MESFET 36, the anode of the Schottky diode 35 being connected to the gate of the enhancement-type MESFET 29. The drain of the MESFET 36 is connected to the cathode of the Schottky diode 35, the gate and drain of the MESFET 36 are connected to each other and the source of the MESFET 36 is connected to the ground line. As a result, when the output signal has the H-level, the gate voltage of the enhancement-type MESFET 29 is clamped to the voltage of (V_{DF} + V_{TH29}), where V_{DF} is the forward voltage of the Schottky diode 35 and V_{TH29} is the threshold voltage of the enhancement, type MESFET 29. Thus, if the threshold voltage V_{TH36} of the MESFET 36 is equal to the threshold voltage V_{TH29} of the enhancement-type MESFET 29, the voltage at the node 31 does not exceed a voltage of (V_{DF} + V_{TH36} - V_{TH29} = V_{DF}). That is, the voltage at the node 31 does not exceed the forward voltage V_{DF} of the Schottky diode 35.

For example, if the forward voltage V_{DF} of the Schottky diode 35 is equal to 0.7 volts (V_{DF}=0.7) and the threshold voltage V_{TH29} of the enhancement-type MESFET 29 falls within a range of 0.1 - 0.2 volts (V_{TH29} = 0.1 - 0.2), when the output signal OUT has the H-level, the voltage of the node 31 is equal to 0.7 volts. In this case, if the threshold voltage of the next stage circuit falls within a range of 0.3 - 0.5 volts, the input transistor in the next stage circuit can be turned on. Further, when the level of the node 31 is switched from the L-level to the H-level, a current independent of the logical operation is prevented from flowing from the power supply line 27 (VDD) to the input transistor in the next stage circuit via the enhancement-type MESFET 29. Thus, the lower dissipation power can be obtained.

Also, the transistor for the pull-up in the push-pull circuit 28 is formed of the enhancement MESFET 29 which is not always in the ON state. That is, when the output signal OUT should have the H-level, the enhancement type MESFET 29 is in the ON state, and when the output signal should have the L-level, the enhancement-type MESFET 29 is in the OFF state. Thus, the W/L ratio of the MESFET 30 for the pull-down can be small so that the input capacity can be small.

The inverter 24 with the output driver circuit 28 can be provided with a large load drivability, a low dissipation power and a low input capacity. In addition, since the level at the node 31 when the output signal OUT has the H-level can be relatively high, the processing speed of the circuit can be relatively high.

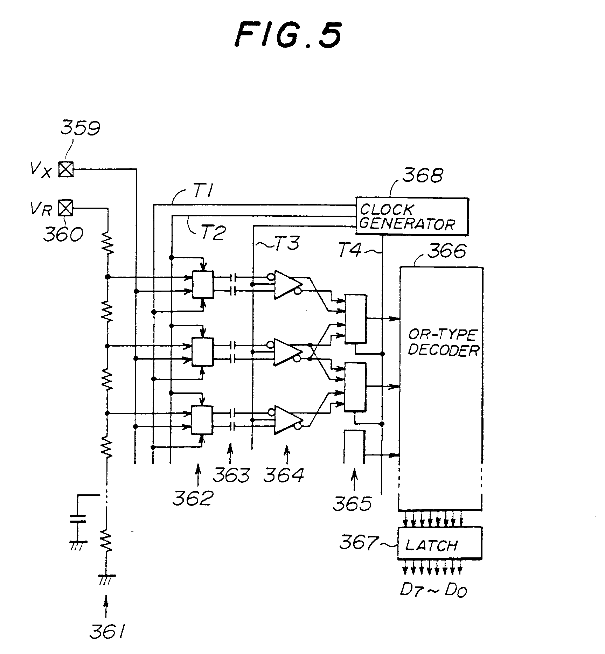

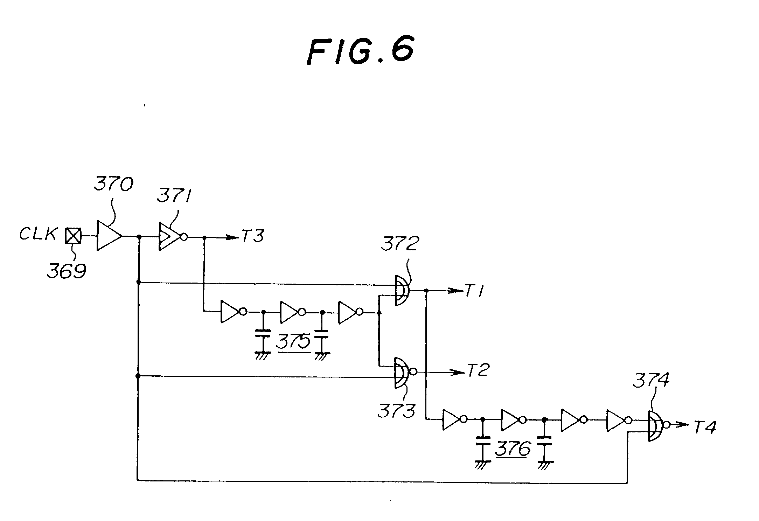

Further logic gate circuits embodying the invention will be described further below with reference to FIGS. 5 and 6 which show an analog-to-digital converter circuit and its clock generator circuit respectively.

Referring to FIG. 5, the A/D converter has an analog voltage input terminal 359, a reference voltage input terminal 360, a voltage divider circuit 361, a switching circuit array 362, a capacitor array 363, a comparing circuit array 364, a latch circuit array 365, an OR-type decoder 366, a latch circuit 367 having digital outputs D7 - D0 and a timing signal generating circuit 368. An analog voltage V_{X} and a reference voltage V_{R} are respectively input to the analog voltage input terminal 359 and the reference voltage input terminal 360. The switching circuit array 362 is used to get the analog voltage V_{X} and divided reference voltages obtained by the voltage divider circuit 363. Comparison results obtained by the comparing circuit array 364 are latched by the latch circuit array 365. The OR-type decoder 366 decodes the comparison results latched by the latch circuit array 365. The output of the OR-type decoder 366 is latched by the latch circuit 367. The timing signal generating circuit 368 generates timing signals T1, T2, T3 and T4. The timing signals T1 and T2 are supplied to respective switching circuits of the switching circuit array 362. The timing signal T3 is supplied to respective comparing circuits of the comparing circuit array 364. The timing signal T4 is supplied to respective latch circuits of the latch circuit array 365.

The timing signal generating circuit 368 is shown in more detail in FIG. 6.

Referring to FIG. 6, the timing signal generating circuit 368 has an input terminal 369 to which a clock signal CLK is input, a TTL buffer 370, an inverter 371 with an output driver, an OR gate 372 with an output driver, NOR gates 373 and 374 (each of which has an output driver) and delay circuits 375 an 376.

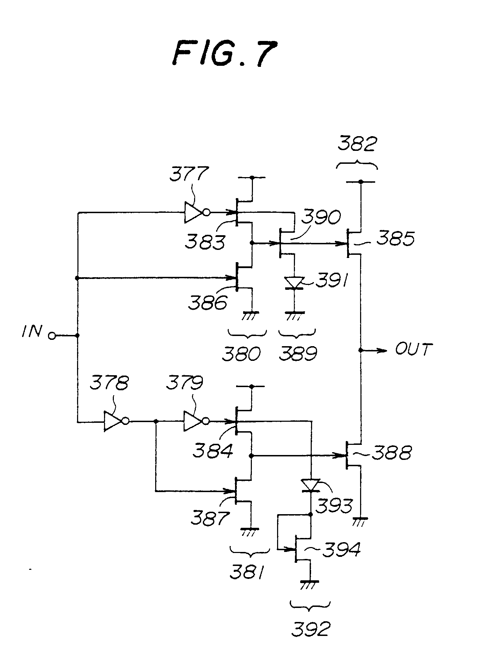

Each of the circuit features 371 and 374 shown in FIG. 6 comprises a logic gate circuit embodying the invention and these circuit features are now described in turn with reference to FIGS. 7 to 9.

The inverter 371 with the output driver is formed as shown in FIG. 7.

Referring to FIG. 7, the inverter 371 has inverters 377 - 379, push-pull circuits 380 - 382 and clamping circuits 389 and 392. The push-pull circuits 380 - 382 have enhancement-type MESFETs 383 385 for the pull-up and enhancement-type MESFETs 386 388 for the pull-down. The clamping circuit 389 clamps the output of the push-pull circuit 380 at an appropriate level when the push-pull circuit 380 outputs the H-level and is formed of an enhancement-type MESFET 390 and a Schottky diode 391. The clamping circuit 392 clamps the gate voltage of the MESFET 384 so that the output of the push-pull circuit 381 has an appropriate level when the push-pull circuit 381 outputs the H-level. The clamping circuit 392 has a Schottky diode 393 and an enhancement-type MESFET 394.

As will be appreciated, the push-pull circuit 380 and clamping circuit 389 of FIG. 7 have the same arrangement as in FIG. 2, whereas the logic gate stage, which is also an inverter, is differently configured.

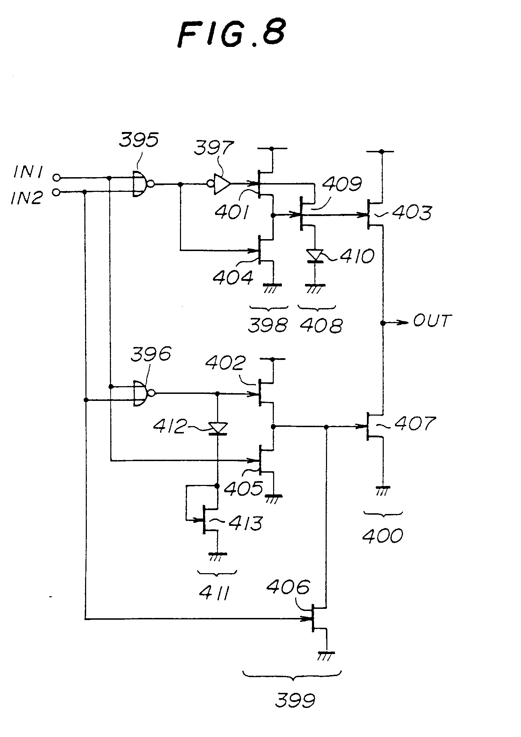

The OR gate 372 with its output driver is formed as shown in FIG. 8.

Referring to FIG. 8, the OR gate 372 has NOR gates 395 and 396, an inverter 397, push-pull circuits 398 - 400 and clamping circuits 408 and 411. The push-pull circuits 398 - 400 are formed of enhancement-type MESFETs 401 - 403 for the pull-up and enhancement-type MESFETs 404 - 407 for the pull-down. The clamping circuit 408 clamps the gate voltage of the MESFET 401 so that the output of the push-pull circuit 398 has an appropriate level when the push-pull circuit 398 outputs the H-level. The clamping circuit 408 is formed of an enhancement-type MESFET 409 and the Schottky diode 410. The clamping circuit 411 clamps the gate voltage of the MESFET 402 so that the output of the push-pull circuit 399 has an appropriate level when the push-pull circuit 399 outputs the H-level. The clamping circuit 411 is formed of a Schottky diode 412 and an enhancement-type MESFET 413.

As will be appreciated, the push-pull circuit 398 and clamping circuit 408 of FIG. 8 have the same arrangement as in FIG. 2, whereas the logic gate stage is an OR gate.

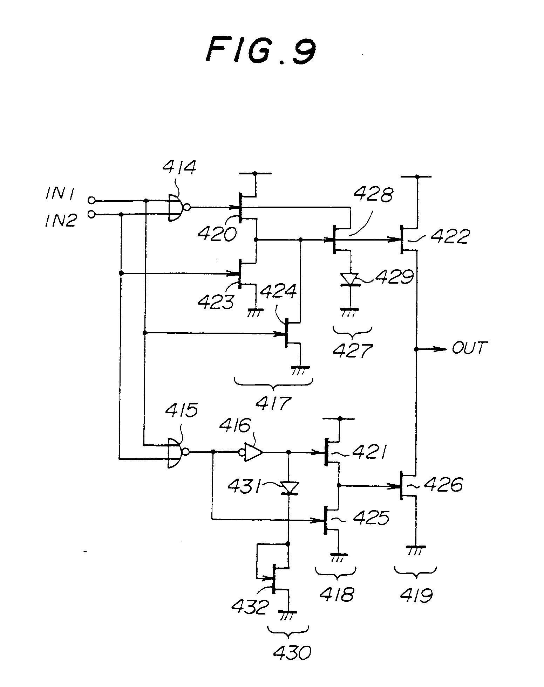

Each of the NOR gates 373 and 374, each of which has an output driver, is formed as shown in FIG. 9.

Referring to FIG. 9, each of the NOR gates 373 and 374 has NOR gates 414 and 415, an inverter 416, push-pull circuits 417 - 419 and clamping circuits 427 and 430. The push-pull circuit 417 is formed of an enhancement-type MESFET 420 for the pull-up and enhancement-type MESFETs 423 and 424 for the pull-down. The push-pull circuits 418 and 419 are formed of enhancement-type MESFETs 421 and 422 for the pull-up and the enhancement-type MESFETs 425 and 426 for the pull-down. The clamping circuit 427 clamps the output of the push-pull circuit 424 at an appropriate level when the push-pull circuit 424 outputs the H-level and is formed of an enhancement MESFET 428 and a Schottky diode 429. The clamping circuit 430 clamps the gate voltage of the MESFET 421 so that the output of the push-pull circuit 418 has an appropriate level when the push-pull circuit 418 outputs the H-level. The clamping circuit 430 is formed of a Schottky diode 431 and an enhancement-type MESFET 432.

As will be appreciated, the push-pull circuit 417 and clamping circuit 427 of FIG. 9 have substantially the same arrangement as in FIG. 2, but for the addition of a further enhancement-type MESFET 424 for the pull-down in the push-pull circuit 417. The logic gate stage is a NOR gate.

In the above, it has been shown how logic gate circuits embodying the invention may be incorporated in larger circuits with different logic gate stages.

## Claims

1. A logic gate circuit comprising:
a logic gate stage (24; 377-379; 395-397; 414-416) having an input for receiving an input signal (IN) and an output for outputting a signal (OUT) depending on a state of the input signal (IN);
a push-pull circuit (28; 380) forming at least a part of an output driver stage and having a pull-up circuit formed of an enhancement-type transistor (29; 383) and a pull-down circuit (30; 386), said enhancement-type transistor (29; 383) having a drain connected to a first line to be maintained at a first voltage (VDD), a gate connected to receive the signal output from said logic gate stage (24; 377-379; 395-397; 414-416) and a source connected to said pull-down circuit (30; 386), said pull-down circuit (30; 386) being connected to a second line to be maintained at a second voltage (GND) less than the first voltage (VDD) and arranged to receive and be controlled by the input signal (IN) ; and
a clamping circuit (37; 389) for clamping a gate voltage of said transistor (29; 383) at a limited voltage so that a node (31; - ) via which the source of said enhancement-type transistor (29; 383) and said pull-down circuit (30; 386) are connected has a high level, said node (31; - ) being an output terminal of said logic gate circuit and the clamping circuit (37; 389) having a further enhancement-type transistor (38; 390), the clamping circuit (37; 389) comprising a Schottky diode (39; 391), the anode of which is connected to a source of said further enhancement-type transistor (38; 390) and the cathode of which is connected to said second line, said further enhancement-type transistor (38; 390) having a drain connected to the gate of said first-mentioned enhancement-type transistor (29; 383), a gate connected to said node (31; - ) and a threshold voltage of approximately 0 volts, **characterised by** a further push-pull circuit (228; 382; 400; 419), additional to said first-mentioned pull-up circuit (380), forming an additional part of the output driver stage and having a further pull-up circuit formed of another enhancement-type transistor (230; 385; 403; 422) and a further pull-down circuit (231; 388; 407; 426), said other enhancement-type transistor (230; 385; 403; 422) having a drain connected to the first line, a gate connected to receive the signal output from said logic gate stage (380) and a source connected to said further pull-down circuit (231; 388; 407; 426), said further pull-down circuit (231; 388; 407; 426) being connected to the second line.

2. A logic gate circuit according to claim 1, having a bootstrap capacitor (CGS) connected between the gate and source of said other enhancement-type transistor (230) and a further clamping circuit (234) for restraining the increase of the gate voltage of said other enhancement-type transistor (230), the further clamping circuit (234) comprising a further Schottky diode (235) the anode of which is connected to the gate of said other enhancement-type transistor (230) and the cathode of which is connected to the source and to the gate of yet another enhancement-type transistor (236), the drain of which is connected to said second line.

3. A logic gate circuit according to claim 1 or 2, wherein said first-mentioned enhancement-type transistor (29) is a compound semiconductor transistor.

4. A logic gate circuit according to claim 1, 2 or 3, wherein said logic gate stage (24) has a depletion-type transistor (26) as a load and a driver circuit (25), said depletion-type transistor (26) having a drain connected to the first line and a gate and source which are connected to each other, said driver circuit (25) being located between the source of said depletion-type transistor (26) and the second line, the input signal being input to said driver circuit (25) so that the driver circuit is controllable in accordance with the state of the input signal.

5. A logic gate circuit according to claim 4, wherein said driver circuit comprises a still further enhancement-type transistor (25) having a drain connected to the source of said depletion-type transistor (26), a source connected to said second line and a gate connected to receive the input signal, wherein the pull-down circuit (30) comprises a yet still further enhancement-type transistor (30) having a drain connected to the source of said first-mentioned enhancement-type transistor (29) for the pull-up, a source connected to said second line and a gate connected to receive the input signal.

6. A logic gate circuit according to any one of the preceding claims, wherein the logic gate stage (24; 377 - 379) is an inverter.

7. A logic gate circuit according to any one of claims 1 to 5, wherein the logic gate stage (395 - 397) is an OR gate.

8. A logic gate circuit according to any one of claims 1 to 5, wherein the logic gate stage (414 - 416) is a NOR gate.

9. A clock generator circuit comprising a logic gate circuit according to any one of the preceding claims.

10. A clock generator circuit comprising a logic gate circuit (371) according to claim 6, a logic gate circuit (372) according to claim 7 and two logic gate circuits (373, 374) according to claim 8, said logic gate circuits being arranged and configured to output respective timing signals (T1 - T4) from the clock generator circuit in response to a common clock signal (CLK).

## Patentansprüche

1. Logikgatterschaltkreis umfassend:
eine Logikgatterstufe (24; 377-379; 395-397; 414-416) mit einem Eingang zum Empfangen eines Eingangssignals (EIN) und einem Ausgang zum Ausgeben eines Signals (AUS) in Abhängigkeit von einem Zustand des Eingangssignals (EIN);
einen Gegentakt-Schaltkreis (28; 380), welcher wenigstens einen Teil einer Ausgangstreiberstufe bildet und einen aus einem Transistor (29; 383) vom Anreicherungs-Typ gebildeten Heraufsetz-Schaltkreis sowie einen Herabsetz-Schaltkreis (30; 386) aufweist, wobei der Transistor (29; 383) vom Anreicherungs-Typ eine Drain (Senke) aufweist, welche mit einer ersten, auf einer ersten Spannung (VDD) zu haltenden Leitung verbunden ist, ein Gate (Steuergate), welches so angeschlossen ist, daß es das von der Logikgatterstufe (24; 377-379; 395-397; 414-416) ausgegebene Signal empfängt, und eine Source (Quelle), die mit dem Herabsetz-Schaltkreis (30; 386) verbunden ist, wobei dieser Herabsetz-Schaltkreis (30; 386) mit einer zweiten Leitung verbunden ist, die auf einer zweiten, unter der ersten Spannung (VDD) liegenden Spannung (GND) zu halten und so angeordnet ist, daß sie das Eingangssignal (EIN) empfängt und von diesem gesteuert wird; und
einen Klemm-Schaltkreis (37; 389) zum Festhalten einer Gatespannung dieses Transistors (29; 383) auf einer begrenzten Spannung, so daß ein Knoten (31; -), über welchen die Source des Transistors (29; 383) vom Anreicherungs-Typ und der Herabsetz-Schaltkreis (30; 386) verbunden sind, einen hohen Pegel hat, wobei dieser Knoten (31; -) ein Ausgangsanschluß dieses Logikgatterschaltkreises ist und der Klemm-Schaltkreis (37; 389) einen weiteren Transitor (38; 390) vom Anreicherungs-Typ hat, wobei der Klemm-Schaltkreis (37; 389) eine Schottky-Diode (39; 391) aufweist, deren Anode mit einer Source dieses weiteren Transistors (38; 390) vom Anreicherungs-Typ verbunden ist und deren Kathode mit der zweiten Leitung verbunden ist, wobei dieser weitere Transistor (38; 390) vom Anreicherungs-Typ eine mit dem Gate des zuerst genannten Transistors (29; 383) vom Anreicherungs-Typ verbundene Drain, ein mit dem Knoten (31; -) verbundenes Gate und eine Schwellenspannung von annähernd 0 Volt hat, **gekennzeichnet** durch einen weiteren Gegentakt-Schaltkreis (228; 382; 400; 419) zusätzlich zu dem zuerst genannten Heraufsetz-Schaltkreis (380), welcher einen zusätzlichen Teil der Ausgangstreiberstufe bildet und welcher einen weiteren Heraufsetz-Schaltkreis, der aus einem anderen Transistor (230; 385; 403; 422) vom Anreicherungs-Typ gebildet ist, sowie einen weiteren Herabsetz-Schaltkreis (231; 388; 407; 426) aufweist, wobei dieser andere Transitor (230; 385; 403; 422) vom Anreicherungs-Typ eine mit der ersten Leitung verbundene Drain, ein Gate, das so angeschlossen ist, daß es das von der Logikgatterstufe (380) ausgegebene Signal empfängt, und eine mit dem weiteren Herabsetz-Schaltkreis (231; 388; 407; 426) verbundene Source aufweist, wobei der weitere Herabsetz-Schaltkreis (231; 388; 407; 426) mit der zweiten Leitung verbunden ist.

2. Logikgatterschaltkreis gemäß Anspruch 1, mit einem Bootstrap-Kondensator (CGS), der zwischen dem Gate und der Source dieses anderen Transistors (230) vom Anreicherungs-Typ angeschlossen ist, und mit einem weiteren Klemm-Schaltkreis (234) zum Beschränken des Anwachsens der Gatespannung des anderen Transistors (230) vom Anreicherungs-Typ, wobei der weitere Klemm-Schaltkreis (234) eine weitere Schottky-Diode (235) umfaßt, deren Anode mit dem Gate dieses anderen Transistors (230) vom Anreicherungs-Typ verbunden ist und deren Kathode mit der Source und mit dem Gate noch eines anderen Transistors (236) vom Anreicherungs-Typ verbunden ist, dessen Drain mit der zweiten Leitung verbunden ist.

3. Logikgatterschaltkreis gemäß Anspruch 1 oder Anspruch 2, bei welchem der zuerst genannte Transistor (29) vom Anreicherungs-Typ ein Verbindungshalbleitertransistor ist.

4. Logikgatterschaltkreis gemäß Anspruch 1, 2 oder 3, bei welchem die Logikgatterstufe (24) einen Transistor (26) vom Verarmungs-Typ als Last und einen Treiberschaltkreis (25) hat, wobei der Transistor (26) vom Verarmungs-Typ eine mit der ersten Leitung verbundene Drain und ein Gate und eine Source hat, welche miteinander verbunden sind, wobei der Treiberschaltkreis (25) zwischen der Source dieses Transistors (26) vom Verarmungs-Typ und der zweiten Leitung angeschlossen ist, wobei das Eingangssignal in den Treiberschaltkreis (25) eingegeben wird, so daß der Treiberschaltkreis in Entsprechung zu dem Status des Eingangssignals steuerbar ist.

5. Logikgatterschaltkreis gemäß Anspruch 4, bei welchem der Treiberschaltkreis noch einen weiteren Transistor (25) vom Anreicherungs-Typ aufweist, mit einer mit der Source des genannten Transistors (26) vom Verarmungs-Typ verbundenen Drain, einer mit der zweiten Leitung verbundenen Source und einem Gate, welches so angeschlossen ist, daß es das Eingangssignal empfängt, wobei der Herabsetz-Schaltkreis (30) noch einen weiteren Transistor (30) vom Anreicherungs-Typ aufweist, mit einer mit der Source dieses zuerst genannten Transistors (29) vom Anreicherungs-Typ verbundene Drain für das Heraufsetzen, einer mit der zweiten Leitung verbundenen Source und einem Gate, welches so angeschlossen ist, daß es das Eingangssignal empfängt.

6. Logikgatterschaltkreis gemäß einem der vorangehenden Ansprüche, bei welchem die Logikgatterstufe (24; 377 - 379) ein Inverter ist.

7. Logikgatterschaltkreis gemäß einem der Ansprüche 1 bis 5, bei welchem die Logikgatterstufe (395 - 397) ein ODER-Gatter ist.

8. Logikgatterschaltkreis gemäß einem der Ansprüche 1 bis 5, bei welchem die Logikgatterstufe (414 - 416) ein NOR-Gatter ist.

9. Zeittakterzeuger-Schaltkreis, umfassend einen Logikgatterschaltkreis gemäß einem der vorangehenden Ansprüche.

10. Zeittakterzeuger-Schaltkreis, umfassend einen Logikgatterschaltkreis (371) gemäß Anspruch 6, einen Logikgatterschaltkreis (372) gemäß Anspruch 7 und zwei Logikgatterschaltkreise (373, 374) gemäß Anspruch 8, wobei die Logikgatterschaltkreise so angeordnet und konfiguriert sind, daß sie jeweilige Taktsignale (T1 - T4) von dem Zeittakterzeuger-Schaltkreis in Reaktion auf ein gemeinsames Zeittaktsignal (CLK) ausgeben.

## Revendications

1. Porte logique comportant :
un étage de porte logique (24 ; 377-379 ; 395-397 ; 414-416) présentant une entrée pour recevoir un signal d'entrée (IN) et une sortie pour émettre un signal (OUT) en fonction d'un état du signal d'entrée (IN);
un circuit symétrique (28; 380) formant au moins une partie d'un étage de commande du signal de sortie et comprenant un circuit d'excursion haute formé d'un transistor à enrichissement (29 ; 383) et un circuit d'excursion basse (30; 386), ledit transistor à enrichissement (29 ; 383) ayant un drain relié à une première ligne à maintenir à une première tension (VDD), une grille reliée pour recevoir le signal de sortie provenant dudit étage de porte logique (24 377-379 ; 395-397 ; 414-416) et une source reliée audit circuit d'excursion basse (30; 386), ledit circuit d'excursion basse (30 ; 386) étant relié à une seconde ligne à maintenir à une seconde tension (GND) inférieure à la première tension (VDD) et étant disposé pour recevoir, et être commandé par, le signal d'entrée (IN) ; et
un circuit de fixation de niveau (37 ; 389) pour fixer une tension de porte dudit transistor à enrichissement (29 ; 383) à une tension limitée de façon qu'un noeud (31. - ), par l'intermédiaire duquel la source dudit transistor à enrichissement (29 ; 383) et ledit circuit d'excursion basse (30; 386) sont reliés soit au niveau haut, ledit noeud (31. - ) étant une borne de sortie dudit circuit de porte logique et le circuit de fixation de niveau (37 ; 389) comprenant un autre transistor à enrichissement (38 ;390), le circuit de fixation de niveau (37 ; 389) comprenant une diode Schottky (39 ; 391), dont l'anode est reliée à une source dudit autre transistor à enrichissement (38 ; 390) et dont la cathode est reliée à ladite seconde ligne, ledit autre transistor à enrichissement (38 ; 390) ayant un drain relié à la grille dudit transistor à enrichissement mentionné en premier lieu (29 ; 383), une grille reliée audit noeud (31. - ), et une tension de seuil d'environ 0 volt, caractérisé par un autre circuit svmétrique (228 ; 382 ; 400 ; 419) additionnel audit circuit d'excursion haute mentionné en premier lieu (380), formant une partie additionnelle de l'étage d'attaque de sortie et comprenant un autre circuit d'excursion haute formé d'un autre transistor à enrichissement (230 ; 385 ; 403; 422) ainsi qu'un autre circuit d'excursion basse (231 ; 388; 407 ; 426), ledit autre transistor à enrichissement (230 ; 385 ; 403 ; 422) ayant un drain relié à la première ligne, une grille reliée pour recevoir le signal de sortie provenant dudit étage de porte logique (380) et une source reliée audit autre circuit d'excursion basse (231 ; 388 ; 407 ; 426), ledit autre circuit d'excursion basse (231 ; 388; 407 ; 426) étant relié à la seconde ligne.

2. Porte logique selon la revendication 1, comportant un condensateur auto-élévateur (CGS) relié entre la grille et la source dudit autre transistor à enrichissement (230) et un autre circuit de fixation de niveau (234) pour empêcher l'accroissement de la tension de grille dudit autre transistor à enrichissement (230), l'autre circuit de fixation de niveau (234) comprenant une autre diode Schottky (235) dont l'anode est reliée à la grille dudit autre transistor à enrichissement (230) et dont la cathode est reliée à la source et à la grille d'un autre encore transistor à enrichissement (236) dont le drain est relié à ladite seconde ligne.

3. Porte logique selon la revendication 1 ou 2, dans laquelle ledit transistor à enrichissement mentionné en premier lieu (29) est un transistor à semiconducteur à action combinée.

4. Porte logique selon la revendication 1, 2 ou 3, dans laquelle ledit étage de porte logique (24) comporte un transistor à déplétion (26) comme charge et un circuit d'attaque (25), ledit transistor à déplétion (26) ayant un drain relié à la premier ligne et une grille et une source qui sont reliées l'une à l'autre, ledit circuit d'attaque (25) étant situé entre la source dudit transistor à déplétion (26) et la seconde ligne, le signal d'entrée entrant dans ledit circuit d'attaque (25) de façon que le circuit d'attaque puisse être commandé en fonction de l'état du signal d'entrée.

5. Porte logique selon la revendication 4, dans laquelle ledit circuit d'attaque comporte encore un autre transistor à enrichissement (25) ayant un drain relié à la source dudit transistor à déplétion (26), une source reliée à ladite seconde ligne et une grille reliée pour recevoir le signal d'entrée, dans laquelle le circuit d'excursion basse (30) comprend un autre encore transistor à enrichissement (30) ayant un drain relié à la source dudit transistor à enrichissement (29) pour l'excursion haute mentionné en premier lieu, une source reliée à ladite seconde ligne et une grille reliée pour recevoir le signal d'entrée.

6. Porte logique selon l'une quelconque des revendications précédentes, dans laquelle l'étage de porte logique (24 ; 377 - 379) est un inverseur.

7. Porte logique selon l'une quelconque des revendications 1 à 5, dans laquelle l'étage de porte logique (395 - 397) est une porte OU.

8. Porte logique selon l'une quelconque des revendications 1 à 5, dans laquelle l'étage de porte logique (414 - 416) est une porte OU inversé.

9. Circuit générateur d'impulsions d'horloge comportant une porte logique conforme à l'une quelconque des revendications précédentes.

10. Circuit générateur d'impulsions d'horloge comportant une porte logique (371) conforme à la revendication 6, une porte logique (372) conforme à la revendication 7 et deux portes logiques (373, 374) conformes à la revendication 8, lesdites portes logiques étant disposées et configurées pour que le circuit générateur d'impulsions d'horloge émette des signaux de cadencement respectif (T1 - T4) en réponse à un signal d'horloge (CLK).
